# EUROPEAN PATENT SPECIFICATION

(11) **EP 0 580 927 B1**
(45) Date of publication and mention of the grant of the patent: **05.03.1997**
(21) Application number: 92830433.6
(22) Date of filing: 31.07.1992
(51) Int. Cl.: H03F 1/32

(54) **Operational amplifier**
Operationsverstärker
Amplificateur opérationnel

(43) Date of publication of application: 02.02.1994
(73) Proprietor: SGS-THOMSON MICROELECTRONICS S.r.l., 20041 Agrate Brianza (Milano) (IT)
(72) Inventor: Lari, Ferdinando, IT-20059 Vimercate (MI) (IT); Erratico, Pietro, IT-20100 Milano (IT)
(74) Representative: Checcacci, Giorgio

(56) References cited:
- US-A- 4 929 910
- INSTRUMENTS AND EXPERIMENTAL TECHNIQUES, vol. 21, no. 2, March 1978, New York, US, pp. 429-430; N.N. PROKOPENKO: 'DIFFERENTIAL OPERATIONAL AMPLIFIER WITH IMPROVED RESPONSE TIME'
- PATENT ABSTRACTS OF JAPAN vol. 13, no.439 (E-827) 3 October 1989 & JP-A-11 68 052
- PATENT ABSTRACTS OF JAPAN vol. 15, no. 054 (E-1031)8 Februar 1991 & JP-A-22 83 070

## Description

This invention relates to an operational amplifier of a type which comprises a differential cell transconductor input stage incorporating a current mirror provided with a pair of degenerative resistors and a gain stage directly driven by a transistor in said mirror.

The construction of amplifiers of the above type is usually completed by an output buffer connected after the gain stage and fed back to one of the signal inputs.

As is well known, in the specific field of application of this invention, there exists a demand for optimization of the amplifier input stage performance.

For that purpose, two so-called degenerative resistors are usually provided which are respectively associated with corresponding input and output legs of the current mirror incorporated to the input stage.

The current mirror is sized to have, in normal operation, the voltage across each of the resistors at approximately 200 mV. In this way, the collector/emitter voltage of the transistor which drives the gain stage can be held at a value of about 1.2 Volts, thereby preventing it from becoming saturated.

It may happen, however, that under some particular operating conditions, such as on the sudden occurrence of deep variations in the supply voltage, "breakdowns" appear in the npn or pnp junctions of the transistors incorporated to the input stage.

This generates high breakdown currents which propagate to the current mirror and cause the transistor driving the gain stage to become saturated. The gain stage usually comprises a pair of transistors connected together into a Darlington configuration.

If this stage is driven into powerful conduction, it will in turn drive the output buffer to potentials close to the value of the negative supply voltage, e.g. the ground value.

If, as is often the case, the amplifier includes a feedback connection between its output and inverting input, then this input will also be driven to a potential close to the ground value, thereby holding the breakdown currents.

All this results in an actual latch-up state of the device, and the latter can come out of that state no more.

To avoid such a serious drawback, the prior art has proposed of connecting a diode in parallel with one of the degenerative resistors, namely that associated with the input leg of the current mirror.

In practice, this diode is formed by an npn transistor having its base shorted to the collector and connected between one end of said resistor and ground.

While being in several ways beneficial and substantially achieving its objective, this prior approach requires the provision of an additional element for which a suitable area must be reserved on the amplifier integrated circuit.

The underlying technical problem of this invention is to provide an improved amplifier which has such constructional and functional features as to overcome the limitations to prior art solutions, while minimizing the area to be occupied on the amplifier integrated circuit.

The inventive idea on which this invention stands is one of exploiting the presence of a parasitic diode associated with the degenerative resistors.

Based on this idea, the technical problem is solved by an amplifier as previously indicated and defined in the characterizing portions of the appended claims.

The features and advantages of an amplifier according to this invention will be apparent from the following detailed description of an embodiment thereof, given by way of example and not of limitation with reference to the accompanying drawings.

In the drawings:

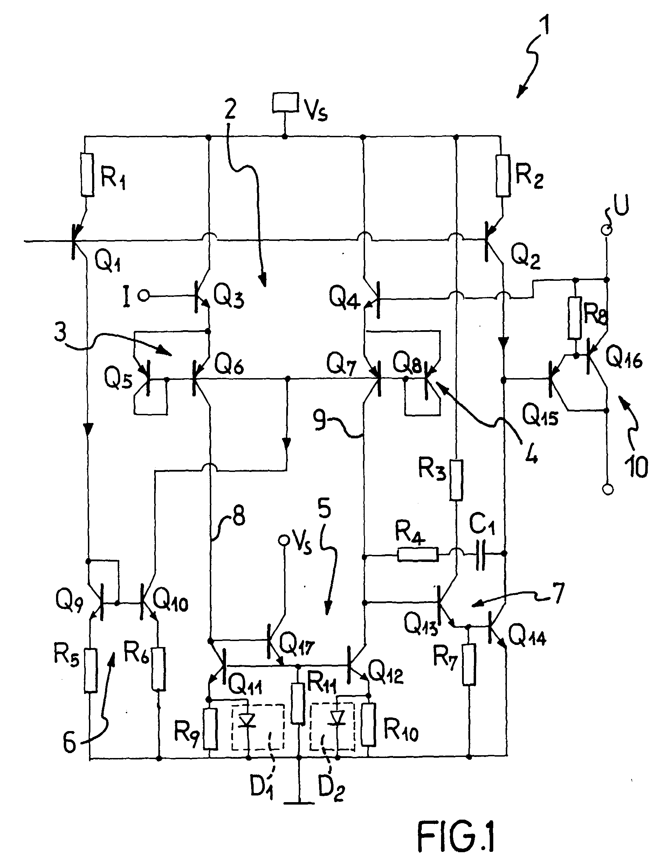

Figure 1 is a diagramatic representation of an amplifier embodying this invention;
Figure 2 is a top plan view, drawn to an enlarged scale, of a detail of a monolithically integrated circuit included to the amplifier of this invention; and
Figure 3 is a vertical section view, taken along section line III-III, showing schematically the detail of Figure 2.

With reference to the drawing views, generally and schematically shown at 1 is an operational amplifier embodying this invention.

This amplifier 1 comprises a differential cell input stage 2 which incorporates a pair of bipolar transistors Q3, Q4 of the npn type connected in common collector configuration to a voltage supply Vs.

The respective bases B3, B4 of such transistors are the input terminals of stage 2. More particularly, the base B3 provides the non-inverting (+) input of the amplifier, while the base B4 is the inverting (-) input.

Each of the two transistors Q3, Q4 has a corresponding emitter, E3, E4, connected to a current mirror circuit portion.

The emitter E3 is associated with a current mirror 3, whilst the emitter E4 is associated with a corresponding current mirror 4.

Each of said current mirrors 3, 4 is composed of a pair of pnp bipolar transistors, one of which is in diode configuration.

Thus, a first pair Q5, Q6 form the current mirror 3, and a second pair Q7, Q8 form the other current mirror 4.

The transistors of both pairs Q5, Q6 and Q7, Q8 have their bases in common and are connected to the collector C10 of an npn transistor Q10 having its emitter connected to ground via a 0.5 kΩ resistor R6.

The base B10 of the last-mentioned transistor Q10 is in common with the base B9 of another npn transistor Q9 which forms a current mirror 6 in combination with the former.

The transistor Q9 is a diode configuration, it having the base B9 and collector C9 in common, whilst the emitter E9 is connected to ground via a resistor R5 of 1 kΩ.

The collector C9 is also connected to the collector C1 of a bias transistor Q1 of the pnp type which is connected to the voltage supply Vs through its emitter E1 and a resistor R1 of 4 kΩ. Advantageously, the input stage 2 of the amplifier 1 comprises a further current mirror circuit portion 5 having input and output legs 8 and 9 associated with each of the non-inverting (+) and inverting (-) signal inputs, respectively.

This current mirror 5 comprises a pair of transistors Q11 and Q12 having their bases B11 in common and being connected to ground through a resistor R11. The second, Q12, of such transistors is intended for driving a gain stage 7 connected after the input stage 2.

A third transistor Q17 of the npn type passes base current to the transistors Q11, Q12, and has its base B17 connected to the collector Q11 of the first transistor in the mirror 5.

The respective collectors C11 and C12 of said transistors Q11, Q12 are connected, the one to the current mirror 3, and the other to the current mirror 4.

The emitters E11, E12 of transistors Q11, Q12 are instead connected to ground through respective so-called degenerative resistors R9, R10.

These degenerative resistors are included to optimize the performance of the current mirror 5.

The aforesaid gain stage 7 comprises a pair of transistors Q13, Q14, both of the npn type, connected in a Darlington configuration.

The first of such transistors in the stage 7 has its base B13 connected to the collector C12 of transistor Q12, its emitter connected to ground through a resistor R7 of 18 kΩ, and its collector connected to the supply Vs through another resistor R3 of 10 kΩ. The other transistor Q14 of the Darlington pair has its emitter connected to ground and its collector C14 connected both to the base B13, through the RC series circuit of a capacitor C1 and a resistor R4 of 0.5 kΩ, and to a bias transistor Q2 connected in parallel with transistor Q1 via a 2 kΩ resistor R2.

Said collector C14 is also connected to an output buffer 10 comprising, in turn, a pair of transistors Q15, Q16 in Darlington configuration having their collectors in common and emitters E15, E16 connected to the inverting (-) input of the stage 2, the former through a 20 kΩ resistor R8.

These emitters constitute essentially an output terminal U for the amplifier 1.

Reverting now to the construction of the current mirror 5 incorporated to the input stage 2, it should be noted that the degenerative resistors R9, R10 are implemented in monolithic form within an epitaxial well 11 doped N-. The well 11 is formed above a semiconductor surbstrate 12 with the partial interposition of a buried layer 13. These resistors are formed by a scattering process, e.g. using the same P-dope scattering step as used to form the common base for the npn transistors Q11 and Q12. Alternatively, the resistors could be formed by P-type ion implantation 14.

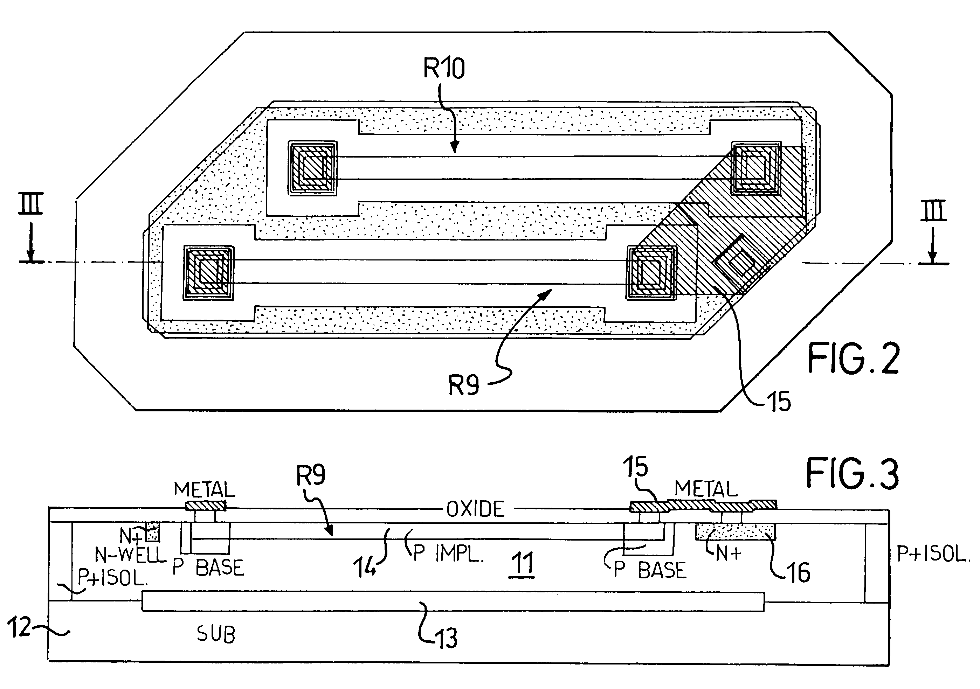

Shown schematically in Figure 3 is an enlarged scale vertical section of the semiconductor integrated circuit incorporating said resistors.

As can be seen, the N-P junction between the epitaxial well 11 and each resistor R9, R10 constitutes a parasitic diode.

Advantageously, according to the invention, this parasitic diode is connected in parallel with its corresponding degenerative resistor through a contact region 16, doped N+, and a metallization layer 15.

More particularly, a first diode D1 is connected in parallel with resistor R9, and a second diode D2 is in parallel with the other resistor R10.

These connections are implemented substantially by forward biasing the P-N junction. That is, the epitaxial well 11 which contains the resistors R9 and R10 is biased to the lowest of the potentials applied to the resistors.

The diodes D1 and D2 are, in turn, forward biased to a potential of about 200 millivolts.

As is well-recognized, at room temperature, the threshold voltage is, for a P-N junction, of 600-700 millivolts; accordingly, the connection provided by this invention will introduce no perturbation in the amplifier operation.

In the event, as described in the preamble to this application, of a particular operating condition being met which involves deep sudden variations in the supply voltage, the circuit structure of this invention would then be able to prevent the transistor Q12 driving the gain stage 7 from becoming saturated.

Specifically, should such a particular operating condition result in high currents being flown through the transistors Q3, Q5 and Q6, then the voltage across the resistors R9 and R19 would still be locked to a value of about 600 millivolts by the diodes D1, D2 respectively provided in the epitaxial well 11.

In this way a possible saturation of transistor Q12 is avoided, and with it, the latching up of the amplifier.

It matters to observe that the solution proposed by this invention solves the technical problem in substantially the opposite way from what the prior art has suggested.

In fact, the presence of any parasitic diodes in the integrated circuit would conventionally be annihilated by shorting out their opposed ends.

The solution proposed by this invention avoids instead the latch-up phenomenon without resorting to the use of any additional components and while minimizing the surface area occupied by the integrated circuit.

## Claims

1. An operational amplifier of a type which comprises a differential cell transconductor input stage (2) incorporating a current mirror (5) provided with a pair of degenerative resistors (R9,R10), and a gain stage (7) driven directly by a transistor (Q12) in said mirror, characterized in that each degenerative resistor (R9,R10) is implemented within an epitaxial well wherewith a parasitic diode (D1,D2) is associated, and that each diode (D1,D2) is connected in parallel with a corresponding one of said resistors (R9,R10).

2. An amplifier according to Claim 1, characterized in that one (D2) of said diodes is connected between the emitter (E12) of said transistor (Q12) and ground.

3. An amplifier according to Claim 1, characterized in that said epitaxial well is doped N-, whereas said resistors (R9,R10) are doped P.

4. An amplifier according to Claim 1, characterized in that each diode (D1,D2) is connected between the emitter (E11,E12) of a corresponding transistor (Q11,Q12) in said mirror (5) and ground.

5. An amplifier according to Claim 1, characterized in that said diodes (D1,D2) are forward biased to a voltage of about 200 millivolts.

6. An amplifier according to Claim 1, characterized in that said diodes (D1,D2) are connected to their corresponding resistor through a contact region (16) and a metallization layer (15).

## Patentansprüche

1. Operationsverstärker vom Typ mit einer Differenzzellen-Transkonduktor-Eingangsstufe (2), die einen Stromspiegel (5) mit einem Paar Gegenkoppelwiderständen (R9, R10) enthält, und mit einer Verstärkungsstufe (7), die direkt von einem Transistor (Q12) in dem Spiegel getrieben wird,
**dadurch gekennzeichnet**,
daß jeder Gegenkopplungswiderstand (R9,R10) in einer epitaktischen Mulde ausgeführt ist, zu der eine parasitäre Diode (D1,D2) gehört, und daß jede Diode (D1,D2) parallel zu einem entsprechenden Widerstand (R9,R10) geschaltet ist.

2. Verstärker nach Anspruch 1,
**dadurch gekennzeichnet,**
daß eine (D2) der Dioden zwischen den Emitter (E12) des Transistors (Q12) und Masse geschaltet ist.

3. Verstärker nach Anspruch 1,
**dadurch gekennzeichnet,**
daß die epitaktische Mulde N- dotiert ist, während die Widerstände (R9,R10) eine P-Dotierung aufweisen.

4. Verstärker nach Anspruch 1,
**dadurch gekennzeichnet,**
daß jede Diode (D1,D2) zwischen den Emitter (E11,E12) eines entsprechenden Transistors (Q11,Q12) in dem Spiegel (5) und Masse geschaltet ist.

5. Verstärker nach Anspruch 1,
**dadurch gekennzeichnet,**
daß die Dioden (D1,D2) auf eine Spannung von etwa 200 Millivolt in Durchlaßrichtung gespannt sind.

6. Verstärker nach Anspruch 1,
**dadurch gekennzeichnet,**
daß die Dioden (D1,D2) mit ihrem entsprechenden Widerstand über eine Kontaktzone (16) und eine Metallisierungsschicht (15) verbunden sind.

## Revendications

1. Amplificateur opérationnel du type comprenant un étage d'entrée transconducteur à cellule différentielle (2), comportant un miroir de courant (5) pourvu d'une paire de résistances de dégénérescence (R9, R10), et un étage de gain (7) directement attaqué par un transistor (Q12) dans ledit miroir, caractérisé en ce que chaque résistance de dégénérescence (R9, R10) est mise en oeuvre à l'intérieur d'un puits épitaxial avec association d'une diode parasite (D1, D2), et en ce que chaque diode (D1, D2) est montée en parallèle sur l'une desdites résistances (R9, R10) correspondante.

2. Amplificateur selon la revendication 1, caractérisé en ce que l'une (D2) desdites diodes est montée entre l'émetteur (E12) dudit transistor (Q12) et la masse.

3. Amplificateur selon la revendication 1, caractérisé en ce que ledit puits épitaxial est à dopage N-, tandis que lesdites résistances (R9, R10 sont dopées P.

4. Amplificateur selon la revendication 1, caractérisé en ce que chaque diode (D1, D2) est montée entre l'émetteur (E11, E12) d'un transistor correspondant (Q11, Q12) dans ledit miroir (5) et la masse.

5. Amplificateur selon la revendication 1, caractérisé en ce que lesdites diodes (D1, D2) sont polarisées dans le sens direct à une tension d'environ 200 millivolts.

6. Amplificateur selon la revendication 1, caractérisé en ce que lesdites diodes (D1, D2) sont reliées à leur résistance correspondante par l'intermédiaire d'une zone de contact (16) et d'une couche de métallisation (15).
